# EUROPÄISCHE PATENTANMELDUNG

(11) **EP 1 507 040 A1**
(43) Veröffentlichungstag der Anmeldung: **16.02.2005**
(21) Anmeldenummer: 03018343.8
(22) Anmeldetag: 13.08.2003
(51) Int. Cl.: D21F 1/00, D21F 7/08

(54) **Textilerzeugnis mit einem integrierten Sensor zur Messung von Druck und Temperatur**

(71) Anmelder: Heimbach GmbH & Co., 52353 Düren (DE)
(72) Erfinder: Best, Walter, Dr., 52351 Düren (DE); Gerundt, Sebastian, 52249 Eschweiler (DE)
(74) Vertreter: Paul, Dieter-Alfred, Dipl.-Ing.

(57) **Zusammenfassung**

Die Erfindung betritt ein Textilerzeugnis, insbesondere zum Einsatz in einer Papiermaschine, mit oder aus mindestens einem Trägerelement (1), auf dem ein schichtförmiger Sensor zur Messung von Druck und Temperatur angeordnet ist, welches dadurch gekennzeichnet ist, daß der Sensor aus mindestens drei Schichten (2, 3, 4) gebildet ist, wobei die zweite Schicht (3) piezoelektrische Eigenschaften aufweist und die an der zweiten Schicht (3) anliegenden Schichten (2,4) Elektroden bilden, die mit einer Auswerteeinrichtung koppelbar sind oder gekoppelt ist.

Die Erfindung betrifft ferner ein Trägerelement, insbesondere für ein Textilerzeugnis zum Einsatz in einer Papiermaschine sowie ein Verfahren zur Herstellung eines solchen Trägerelements.

## Beschreibung

Die Erfindung betrifft ein Textilerzeugnis, insbesondere zum Einsatz in einer Papiermaschine, mit oder aus einem Trägerelement, auf dem ein schichtförmiger Sensor zur Messung von Druck und Temperatur angeordnet ist, das Trägerelement selbst, sowie ein Verfahren zur Herstellung eines Trägerelements für ein Textilerzeugnis.

Ein derartiges Textilerzeugnis ist beispielsweise aus der US 6,158,576 bekannt. Das bekannte Textilerzeugnis weist in seiner Matrix einen Sensor auf, welcher mittels Nd:YAG-Laserstrahlung angeregt wird und dadurch Strahlung mit einer anderen Wellenlänge als der Anregungswellenlänge emittiert. Diese Strahlung wird mittels eines Detektors in der Nähe des Textilerzeugnisses detektiert, so daß es möglich ist, mittels der Intensität und der Amplitude der Wellenlänge der von dem Sensor emittierten Strahlung Informationen wie beispielsweise Geschwindigkeit oder Temperatur des Textilerzeugnisses zu ermitteln.

Ein Hauptnachteil dieser Anordnung ist darin zu sehen, daß die einzelnen Komponenten wie Nd:YAG-Laser, Detektor und Auswertecomputer sehr kostenintensiv sind. Zusätzlich benötigen die einzelnen Komponenten sehr viel Platz, und die Anordnung zueinander ist relativ unflexibel. Dadurch kann die Messung nur an bestimmten Meßpunkten durchgeführt werden, so daß einige Bereiche des Textilerzeugnisses durch die festgelegte Meßanordnung nicht erreichbar sind.

Das Dokument WO 93/21378 offenbart ein berührungsloses Meßverfahren mittels Induktion. Dazu wird in das Textilerzeugnis ein elektrisch leitendes oder ein magnetisierbares Metallband eingewebt. Die Messung dient zur Feststellung der Position des Textilerzeugnisses in der Papiermaschine und erfolgt mittels zweier Detektoren, zwischen denen das Textilerzeugnis hindurchläuft.

Auch hier ist der Nachteil der eingeschränkten Anzahl an Meßpunkten und Unzugänglichkeit bestimmter Prozeßbereiche gegeben. Auch können lediglich Positionierungsfehler des Textilerzeugnisses in der Papiermaschine durch diesen Meßaufbau detektiert werden. Das Messen von Geschwindigkeit, Druck oder Temperatur des Textilerzeugnisses ist nicht möglich.

In dem Dokument DE 43 11 402 A1 ist eine Meßvorrichtung zum Messen der Temperatur und der Wasserdurchlässigkeit eines Papiermaschinenfilzes offenbart, die außerhalb des Papiermaschinenfilzes angeordnet ist. Die Meßvorrichtung weist dazu einen Mikrowellenkopf auf, der mit einer Unterdruckquelle verbunden ist. Der Meßkopf wird auf den Filz aufgesetzt, und der Filz wird mittels einer Unterdruckquelle an den Meßkopf angesaugt. Dabei mißt ein Temperaturmeßwertgeber im Meßkopf die Temperatur der eingesaugten Luft und des eingesaugten Wassers. Gleichzeitig wird mittels eines im Meßkopf befindlichen Mikrowellenstrahlers die Wassermenge, die aus dem Filz gesogen wird, bestimmt. Durch die Temperaturmessung kann eine gleichmäßige Ausbreitung der Entwässerungsenergie der Pressenpartie über die Bahn und darüber hinaus über den Filz verfolgt werden.

Nachteil dieser Meßvorrichtung ist zum einen, daß der Meßkopf auf das Textilerzeugnis bzw. den Papiermaschinenfilz aufgesetzt werden muß. Zum anderen ist die Ausbildung des Meßkopfes mit einem Mikrowellenstrahler zum Messen der Wassermenge im Filz und einem Temperaturgeber zum Messen der Temperatur der durch den Meßkopf in den Luftkanal eingesaugten Luft sehr aufwendig und kostenintensiv. Zudem ist die Anzahl der Meßpunkte zum einen baulich zum anderen aus Kostengründen begrenzt.

Aufgabe der vorliegenden Erfindung ist es, ein Textilerzeugnis bereitzustellen, welches ein platzsparendes und kostengünstiges Messen an beliebig vielen Meßpunkten innerhalb des Textilerzeugnisses ermöglicht.

Erfindungsgemäß wird diese Aufgabe dadurch gelöst, daß in oder auf dem Textilerzeugnis mindestens ein Trägerelement mit einem schichtförmigen Sensor angeordnet ist, der aus mindestens drei Schichten gebildet ist, wobei die zweite Schicht piezoelektrische Eigenschaften aufweist und die an der zweiten Schicht anliegenden Schichten Elektroden bilden, die mit einer Auswerteeinrichtung koppelbar oder gekoppelt sind.

Die piezoelektrische Schicht bildet mit den beiden Elektroden ein System, das Temperatur und Druck sowie die Veränderung bzw. Differenzen letzterer messen kann, weil bei Druck- oder Temperaturbelastung eine Ladungsverschiebung in der piezoelektrischen Schicht erfolgt, durch die Elektronen freigesetzt werden, die von den Elektroden wiederum aufgenommen werden und einer elektronischen Schaltung der Auswerteeinrichtung in Form eines elektrischen Signals zugeführt werden.

Um das Auftragen der zweiten Schicht des Sensors möglichst einfach zu gestalten, besteht die zweite Schicht vorteilhaft aus einem Lack aus einem Polyvinylidenfluorid-Copolymer mit einer Schichtdicke von 10 µm bis 50 µm. Sie ist zur Erziehlung der vorgenannten Eigenschaften polarisiert.

Zur Messung von statischen und dynamischen Belastungen kann eine oder können beide an der zweiten Schicht anliegenden Schichten abschnittsweise unterbrochen sein, wobei bei Unterbrechung nur einer der Schichten die andere als Masseelektrode weiter wirkt. Bei Unterbrechung beider Elektroden sollte folgender Aufbau realisiert werden. Zunächst sollte ein Meßfeld durch die Schichtkombination erste Metallisierungen, Piezolack, zweite Metallisierung, isolierende Lackschicht auf dem Trägerelement realisiert werden. Die Unterbrechung kann durch partielles Weglassen einer der Metallisierungsschichten oder beider Metallisierungsschichten erreicht werden, so daß sich die Schichtfolge Metallisierung, Piezolack, isolierende Lackschicht oder Piezolack, isolierende Lackschicht im Bereich der Unterbrechung ergeben. Daran anschließend ist ein weiteres Meßfeld mit der gleichen Schichtfolge des oben genannten ersten Meßfeldes angeordnet. Durch einen derartigen Aufbau des Sensors kann die an der piezoelektrischen Schicht entstehende elektrische Ladungsverschiebung durch eine ideale Spannungsmessung bestimmt werden. Sowohl statische als auch dynamische Messungen sind so möglich.

Sollen gleichzeitig die bei der Ladungsverschiebung frei werdenden Elektronen als Stromversorgung für den Sensor und/oder die Auswerteeinrichtung genutzt werden, muß eine dynamische Druck- oder Temperaturbelastung vorliegen. Bei statischer Belastung werden außer die bei der ersten Ladungsverschiebung frei werdenden Elektronen keine weiteren Elektronen freigesetzt, die den Sensor bzw. die Auswerteeinrichtung mit Energie versorgen könnten. Bei dynamischer Belastung werden hingegen bei jeder Laständerung wieder Elektronen freigesetzt, durch die der Sensor und/oder die Auswerteeinrichtung mit Strom versorgt werden können.

Zum Schutz des Sensors bzw. der äußeren Metallisierungsschicht z.B. gegen Kurzschlüsse durch Wasser ist auf dem Textilerzeugnis vorteilhaft eine weitere Schicht in Form einer elektrisch isolierenden und/oder einer feuchtigkeitsisolierenden Schicht angeordnet.

Um den notwendigen Bauraum noch weiter zu reduzieren, ist es zweckmäßig, die Auswerteelektronik zusätzlich zu dem Sensor auf dem Trägerelement anzuordnen. Durch diese Anordnung wird nicht nur der Bauraum reduziert. Auch kann je nach Wahl der Auswerteeinrichtung an jedem beliebigen Ort des Textilerzeugnisses in den Bereichen, in denen ein mit dem Sensor versehenes Trägerelement angeordnet ist, zu jedem beliebigen Zeitpunkt eine Messung des Drucks und/oder der Temperatur durchgeführt werden.

Das Trägerelement, das das Textilerzeugnis selbst bilden kann oder in ihm enthalten ist, kann ein gezwirntes oder ungezwirntes Monofilament sein oder eine extrudierte Profilstruktur, die insbesondere in Form von Streifen extrudiert ist. Solche Profilstrukturen sind z. B. in der DE 37 35 709 und der EP 1 035 251 offenbart. Die so erhaltenen kleinen Dimensionen ermöglichen ein einfaches Anordnen des Trägerelements in oder an einem Textilerzeugnis, z.B. durch Einweben in ein Gewebe oder Einlegen in ein Fadengelege oder ein Gewirke. Dabei kann das Trägerelement einen runden, flachen oder einen rechteckigen Querschnitt aufweisen. Die textile Verarbeitbarkeit des Trägerelements bleibt dabei erhalten, so daß das Trägerelement mit integriertem Druck-/Temperatursensor und der Auswerteeinrichtung einschließlich Stromversorgung einfach in das Textilerzeugnis sowohl in Längs- als auch in Querrichtung beliebig eingebaut oder eingewebt werden kann. Das Textilerzeugnis kann beispielsweise aus einem Filz bestehen, in dem das Trägerelement eingewebt wird, oder auch aus einer Kombination aus mit Sensorschichten versehenen und nicht mit Sensorschichten versehenen Trägerelementen bestehen, die beispielsweise miteinander verwebt sein können. Durch die Segmentierung der Beschichtungen lassen sich Signale exakt auf einen Bereich bezogen detektieren. Ist die Temperatur nahezu konstant, erzeugen Druckeinwirkungen auf die Schichten ein mit der Höhe des Druckes korrelierendes elektrisches Signal, welches als Meßsignal ausgewertet werden kann. Bleibt der Druck in bestimmten Bereichen nahezu konstant, bewirken eventuelle Temperaturveränderungen ein mit der Höhe der Temperatur korrelierendes elektrisches Signal, welches als Meßsignal verwendbar ist.

Durch die Möglichkeit des variablen Einbaus des Trägerelements in das Textilerzeugnis in Längs- und/oder Querrichtung ist es möglich, das Trägerelement entsprechend der zu bestimmenden Belastung in dem Textilerzeugnis zu positionieren. Dabei können die Sensorschichten die Oberfläche des Trägerelements ganz oder nur teilweise umgeben.

Die Auswerteeinrichtung kann vorteilhaft eine Signalverarbeitungs- und/oder Übertragungselektronik umfassen. Die Signalverarbeitungselektronik kann vorzugsweise mit Transistoren aus organischen Halbleitern gebildet sein, da diese den textilen Charakter des Textilerzeugnisses erhalten. Auch mit bekannter Halbleitertechnik hergestellte Transistoren können eingesetzt werden. Die Übertragungselektronik kann mittels RFID-Technologie oder mittels OFW-Bauelementen realisiert werden. Bei der RFID-Technologie (Radio Frequency Identification-Technologie) handelt es sich um eine berührungslose Datenübertragung auf der physikalischen Basis elektromagnetischer Wechselfelder. Die dabei eingesetzten RFID-Tags können ohne Sichtverbindung von einem Computer gesteuerten Gerät (Reader) gelesen werden. Die Reichweite liegt im Bereich von bis zu 1 m. Um die auf dem integrierten Chip gespeicherten Informationen lesen zu können, sendet der Reader ein elektromagnetisches Frequenzfeld aus, das durch eine Miniatur-Antenne auf dem RFID-Tag empfangen wird. Über die drahtlose Verbindung können gespeicherte Daten gelesen, verarbeitet und gegebenenfalls geändert werden. Der integrierte Mikrochip (genauer Transponder) wird durch das Radio-Frequenz-Feld des Readers mit Energie versorgt und benötigt daher keine eigene Energiequelle. OFW-Bauteile sind spezielle mikroakustische Elemente und bestehen aus einem piezoelektrischen Substrat, auf dessen polierter Oberfläche Metallstrukturen wie Interdigitalwandler oder Reflektoren aufgebracht sind. Liegt an einem Wandler eine Wechselspannung an, so wird diese aufgrund des inversen Piezoeffekts in eine periodische Verformung der Kristalloberfläche umgewandelt. Diese Verformung breitet sich als akustische Oberflächenwelle (OFW) aus. OFW-Transponder benötigen weder eine Verdrahtung noch Batterien. Sie sind außerdem klein, robust, preisgünstig und äußerst haltbar. Sie überstehen z.B. harte Strahlung, hohe Temperaturen oder Schock. Daher sind sie ideal für einen Einsatz an unzugänglichen Stellen, wie bewegten oder rotierenden Teilen, geeignet. Auf diese Weise kann die Übertragung der Sensorsignale auf dem Funkwege geschehen, wodurch eine noch flexiblere Gestaltung der Anordnung der Ausleseelektronik außerhalb des Textilerzeugnisses ermöglicht wird. Die Auslesung der statischen und dynamischen Messung von Druck und/oder Temperatur kann dabei u.a. mittels idealer Spannungsmessung erfolgen.

Vorteilhafte Ausgestaltungen der Erfindung sind in den Unteransprüchen und der folgenden Figurenbeschreibung offenbart. Es zeigt:
- Figur 1: einen Querschnitt durch ein mit einem erfindungsgemäßen Sensor umgebenes Trägerelement;
- Figur 2: ein Textilerzeugnis in Form eines Trockensiebes mit einem Trägerelement, das ganz oder teilweise mit dem erfindungsgemäßen Sensor umgeben ist; und
- Figur 3: einen Längsschnitt durch ein Trägerelement, auf dem an einer Seite der erfindungsgemäße Sensor angeordnet ist.

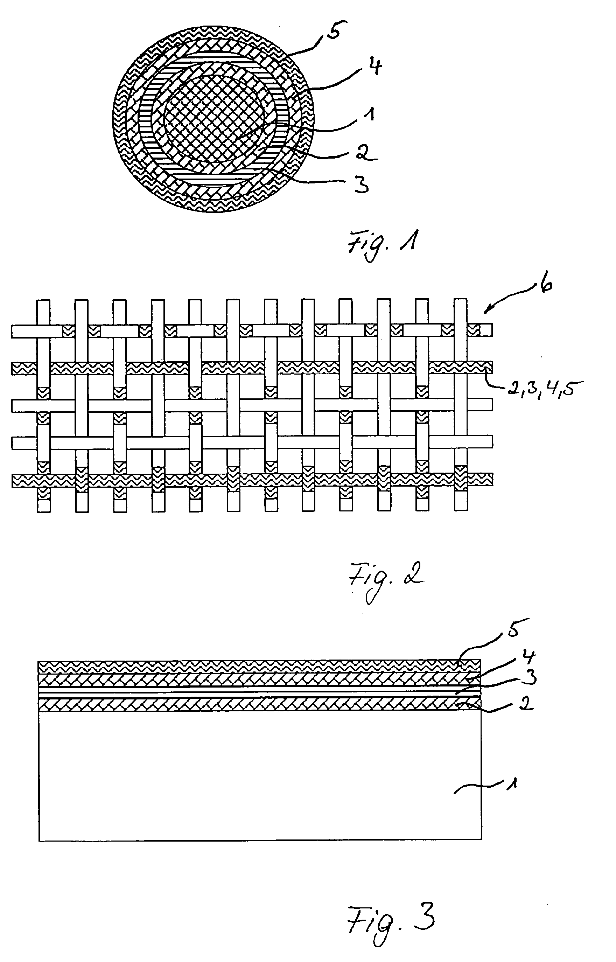

Figur 1 zeigt einen Querschnitt durch ein erfindungsgemäßes Textilerzeugnis, das in diesem Fall als Trägerelement 1 in Form eines Monofilamentes ausgebildet ist, welches von einer ersten Metallisierung 2 vollständig umgeben ist. Auf diese erste Metallisierung 2 ist eine zweite Schicht 3 mit piezoelektrischen Eigenschaften aufgetragen. Es handelt sich dabei um einen Piezolack aus einem Polyvinylidenfluorid-Copolymer, der aufgesprüht oder anders aufgetragen werden kann. Anschließend wird diese Schicht 3 polarisiert und eine zweite Metallisierungsschicht 4 aufgebracht. Eine an die zweite Metallisierungsschicht 4 anliegende Isolationsschicht 5 in Form eines Lackes dient dazu, die darunter liegende Metallisierungsschicht 4 vor Funktionsbeeinträchtigungen und Beschädigungen während des Betriebes zu schützen.

Figur 2 zeigt beispielhaft eine mögliche Anordnung des Trägerelements 1 mit den Sensorschichten 2, 3, 4, 5 in einem Trockensieb 6. Bei Trockensieben 6 spielt der Druck eine untergeordnete Rolle, d.h. er ist im wesentlichen konstant. Wichtig ist aber die Temperatur oder Temperaturdifferenz, die im Trockensieb 6 herrscht. Mit Hilfe der Sensorschichten 2, 3, 4, 5 gemäß der oben beschriebenen Ausführung, kann die Temperatur und die eventuelle Temperaturdifferenz über die Papierbahnbreite beim Trocknungsprozeß gemessen und können so eventuelle Maschinenfehler frühzeitig entdeckt werden.

Würde das Trockensieb 6 auf Druck beansprucht, würden in der zweiten Schicht 3 mit piezoelektrischen Eigenschaften die elektrischen Ladungen verschoben. Die dabei frei werdenden Elektronen könnten von der jeweiligen Elektrode 2 bzw. 4 aufgenommen und einer nicht dargestellten Auswerteeinrichtung zugeführt.

Figur 3 zeigt einen Längsschnitt durch ein Trägerelement 1, welches einseitig mit einem erfindungsgemäßen Sensor beschichtet ist. Das Trägerelement 1 ist als Flachmonofilament ausgebildet, an dessen einer Seite eine Metallisierung 2 angeordnet ist, auf die eine polarisierte Lackschicht 3 mit piezoelektrischen Eigenschaften aufgebracht ist. Auf diese Lackschicht ist eine weitere Metallisierungsschicht 4 aufgebracht, die durch eine Isolationsschicht 5 gegen äußere betriebsbedingte Schädigungen gesichert ist.

## Patentansprüche

1. Textilerzeugnis, insbesondere zum Einsatz in einer Papiermaschine, mit oder aus mindestens einem Trägerelement (1), auf dem ein schichtförmiger Sensor zur Messung von Druck und Temperatur angeordnet ist, **dadurch gekennzeichnet, daß** der Sensor aus mindestens drei Schichten (2, 3, 4) gebildet ist, wobei die zweite Schicht (3) piezoelektrische Eigenschaften aufweist und die an der zweiten Schicht (3) anliegenden Schichten (2,4) Elektroden bilden, die mit einer Auswerteeinrichtung koppelbar sind oder gekoppelt ist.

2. Textilerzeugnis nach Anspruch 1, **dadurch gekennzeichnet, daß** die zweite Schicht (3) polarisiert ist.

3. Textilerzeugnis nach Anspruch 1 oder 2, **dadurch gekennzeichnet, daß** die Dicke der zweiten Schicht (3) 10 µm bis 50 µm beträgt.

4. Textilerzeugnis nach Anspruch 1 bis 3, **dadurch gekennzeichnet, daß** die zweite Schicht (3) aus einem Lack aus einem Polyvinylidenfluorid-Copolymer gebildet ist.

5. Textilerzeugnis nach Anspruch 1 bis 4, **dadurch gekennzeichnet, daß** die an der zweiten Schicht (3) anliegenden Schichten (2, 4) durch Oberflächenmetallisierung ausgebildet sind.

6. Textilerzeugnis nach einem der vorhergehenden Ansprüche, **dadurch gekennzeichnet, daß** eine oder beide an der zweiten Schicht (3) anliegenden Schichten (2, 4) abschnittsweise unterbrochen sind.

7. Textilerzeugnis nach Anspruch 6, **dadurch gekennzeichnet, daß** bei Unterbrechung nur einer der Schichten (2, 4) die andere als Masseelektrode weiter wirkt.

8. Textilerzeugnis nach einem der vorhergehenden Ansprüche, **dadurch gekennzeichnet, daß** auf dem Trägerelement (1) eine weitere Schicht (5) in Form einer elektrisch isolierenden und/oder einer feuchtigkeitsisolierenden Schicht angeordnet ist.

9. Textilerzeugnis nach einem der vorhergehenden Ansprüche, **dadurch gekennzeichnet, daß** die Auswerteeinrichtung zusätzlich zu dem Sensor auf dem Trägerelement (1) angeordnet ist.

10. Textilerzeugnis nach einem der vorhergehenden Ansprüche, **dadurch gekennzeichnet, daß** die Auswerteeinrichtung bei dynamischer Belastung durch den am Sensor erzeugten Strom betreibbar ist.

11. Textilerzeugnis nach einem der vorhergehenden Ansprüche, **dadurch gekennzeichnet, daß** das Trägerelement (1) ein an dem Textilerzeugnis angeordnetes Monofilament oder eine an dem Textilerzeugnis angeordnete, extrudierte Profilstruktur ist, die insbesondere in Form von Streifen extrudiert ist.

12. Textilerzeugnis nach einem der vorhergehenden Ansprüche, **dadurch gekennzeichnet, daß** das Trägerelement (1) einen runden, flachen oder rechteckigen Querschnitt aufweist.

13. Textilerzeugnis nach einem der vorhergehenden Ansprüche, **dadurch gekennzeichnet, daß** das Trägerelement (1) in Längs- und/oder Querrichtung des Textilerzeugnisses eingebaut ist.

14. Textilerzeugnis nach einem der vorhergehenden Ansprüche, **dadurch gekennzeichnet, daß** die Sensorschichten die Oberfläche des Trägerelements (1) mindestens teilweise umgibt.

15. Textilerzeugnis nach einem der vorhergehenden Ansprüche, **dadurch gekennzeichnet, daß** die Auswerteeinrichtung eine Signalverarbeitungs- und/oder Übertragungselektronik umfaßt.

16. Textilerzeugnis nach Anspruch 15, **dadurch gekennzeichnet, daß** die Signalverarbeitungselektronik mindestens einen Transistor mit organischem Halbleiter oder einen mittels Halbleitertechnik hergestellter Transistor aufweist.

17. Textilerzeugnis nach Anspruch 15 oder 16, **dadurch gekennzeichnet, daß** die Übertragungselektronik als RFID-Tag oder OFW-Bauelement ausgebildet ist.

18. Textilerzeugnis nach einem der vorhergehenden Ansprüche, **dadurch gekennzeichnet, daß** die Auslesung der statischen und dynamischen Messung von Druck und/oder Temperatur mittels idealer Spannungsmessung erfolgt.

19. Trägerelement, insbesondere für ein Textilerzeugnis zum Einsatz in einer Papiermaschine, **dadurch gekennzeichnet, daß** das Trägerelement (1) ein Monofilament oder eine an dem Textilerzeugnis angeordnete, extrudierte Profilstruktur ist und von einem Sensor und/oder einer Auswerteeinrichtung nach einem der Ansprüche 1 bis 17 zumindest teilweise umgeben ist.

20. Verfahren zur Herstellung eines Trägerelements (1) für ein Textilerzeugnis nach einem der vorhergehenden Ansprüche, **dadurch gekennzeichnet, daß** in einem ersten Schritt eine Metallisierungsschicht (2) auf das Trägerelement (1) angeordnet wird, in einem weiteren Schritt oberhalb der Metallisierungsschicht (2) eine Schicht (3) mit piezoelektrischen Eigenschaften angeordnet wird, die in einem nächsten Schritt polarisiert wird, und in einem weiteren Schritt eine weitere Metallisierungsschicht (4) oberhalb der Schicht (3) mit piezoelektrischen Eigenschaften angeordnet wird.

21. Verfahren nach Anspruch 20, **dadurch gekennzeichnet, daß** in einem weiteren Schritt eine elektrisch isolierende und/oder eine feuchtigkeitsisolierende Schicht (5) auf dem Trägerelement (1) angeordnet wird.

22. Verfahren nach Anspruch 20 oder 21, **dadurch gekennzeichnet, daß** in einem weiteren Schritt zusätzlich eine Auswerteelektronik nach einem der vorhergehenden Ansprüche auf dem Trägerelement (1) angeordnet wird.

## Geänderte Patentansprüche

### Geänderte Patentansprüche gemäss Regel 86(2) EPÜ.

**1.** Textilerzeugnis, insbesondere zum Einsatz in einer Papiermaschine, mit oder aus mindestens einem Trägerelement (1), auf dem ein schichtförmiger Sensor zur Messung von Druck und/oder Temperatur angeordnet ist, der aus einem Schichtsystem aus mindestens drei Schichten (2, 3, 4) gebildet ist, wobei die zweite Schicht (3) piezoelektrische Eigenschaften aufweist und die an der zweiten Schicht (3) anliegenden Schichten (2, 4) Elektroden bilden, **dadurch gekennzeichnet, daß** eine Auswerteeinrichtung zusätzlich zu dem Sensor an dem Trägerelement (1) angeordnet ist, und die Auswerteeinrichtung mit den an der zweiten Schicht (3) anliegenden Schichten (2, 4) koppelbar oder gekoppelt ist.

**2.** Textilerzeugnis nach Anspruch 1, **dadurch gekennzeichnet, daß** die zweite Schicht (3) polarisiert ist.

**3.** Textilerzeugnis nach Anspruch 1 oder 2, **dadurch gekennzeichnet, daß** die Dicke der zweiten Schicht (3) 10 µm bis 50 µm beträgt.

**4.** Textilerzeugnis nach Anspruch 1 bis 3, **dadurch gekennzeichnet, daß** die zweite Schicht (3) aus einem Lack aus einem Polyvinylidenfluorid-Copolymer gebildet ist.

**5.** Textilerzeugnis nach Anspruch 1 bis 4, **dadurch gekennzeichnet, daß** die an der zweiten Schicht (3) anliegenden Schichten (2, 4) durch Oberflächenmetallisierung ausgebildet sind.

**6.** Textilerzeugnis nach einem der vorhergehenden Ansprüche, **dadurch gekennzeichnet, daß** eine oder beide an der zweiten Schicht (3) anliegenden Schichten (2, 4) abschnittsweise unterbrochen sind.

**7.** Textilerzeugnis nach einem der vorhergehenden Ansprüche, **dadurch gekennzeichnet, daß** bei Unterbrechung nur einer der Schichten (2, 4) die andere als Masseelektrode weiter wirkt.

**8.** Textilerzeugnis nach einem der vorhergehenden Ansprüche, **dadurch gekennzeichnet, daß** auf dem Trägerelement (1) eine weitere Schicht (5) in Form einer elektrisch isolierenden und/oder einer feuchtigkeitsisolierenden Schicht angeordnet ist.

**9.** Textilerzeugnis nach einem der vorhergehenden Ansprüche, **dadurch gekennzeichnet, daß** die Auswerteeinrichtung mittels bei dynamischer Belastung auftretenden Ladungsverschiebungen freiwerdenden Elektronen betreibbar ist.

**10.** Textilerzeugnis nach einem der vorhergehenden Ansprüche, **dadurch gekennzeichnet, daß** das Trägerelement (1) ein an dem Textilerzeugnis angeordnetes Monofilament oder eine an dem Textilerzeugnis angeordnete, extrudierte Profilstruktur ist, die insbesondere in Form von Streifen extrudiert ist.

**11.** Textilerzeugnis nach einem der vorhergehenden Ansprüche, **dadurch gekennzeichnet, daß** das Trägerelement (1) einen runden, flachen oder rechteckigen Querschnitt aufweist.

**12.** Textilerzeugnis nach einem der vorhergehenden Ansprüche, **dadurch gekennzeichnet, daß** das Trägerelement (1) in Längs- und/oder Querrichtung des Textilerzeugnisses eingebaut ist.

**13.** Textilerzeugnis nach einem der vorhergehenden Ansprüche, **dadurch gekennzeichnet, daß** die Sensorschichten die Oberfläche des Trägerelements (1) mindestens teilweise umgeben.

**14.** Textilerzeugnis nach einem der vorhergehenden Ansprüche, **dadurch gekennzeichnet, daß** die Auswerteeinrichtung eine Signalverarbeitungs- und/oder Übertragungselektronik umfaßt.

**15.** Textilerzeugnis nach Anspruch 14, **dadurch gekennzeichnet, daß** die Signalverarbeitungselektronik mindestens einen Transistor mit organischem Halbleiter oder einen mittels Halbleitertechnik hergestellter Transistor aufweist.

**16.** Textilerzeugnis nach Anspruch 14 oder 15, **dadurch gekennzeichnet, daß** die Übertragungselektronik als RFID-Tag oder OFW-Bauelement ausgebildet ist.

**17.** Textilerzeugnis nach einem der vorhergehenden Ansprüche, **dadurch gekennzeichnet, daß** die Auslesung der statischen und dynamischen Messung von Druck und/oder Temperatur mittels idealer Spannungsmessung erfolgt.

**18.** Trägerelement, insbesondere für ein Textilerzeugnis zum Einsatz in einer Papiermaschine, **dadurch gekennzeichnet, daß** das Trägerelement (1) ein Monofilament oder eine an dem Textilerzeugnis angeordnete, extrudierte Profilstruktur ist und von einem Sensor und/oder einer Auswerteeinrichtung nach einem der Ansprüche 1 bis 17 zumindest teilweise umgeben ist.

**19.** Verfahren zur Herstellung eines Trägerelements (1) für ein Textilerzeugnis nach einem der vorhergehenden Ansprüche, **dadurch gekennzeichnet, daß** in einem ersten Schritt eine Metallisierungsschicht (2) auf das Trägerelement (1) angeordnet wird, in einem weiteren Schritt oberhalb der Metallisierungsschicht (2) eine Lackschicht (3) mit piezoelektrischen Eigenschaften aufgetragen wird, die in einem nächsten Schritt polarisiert wird, und in einem weiteren Schritt eine weitere Metallisierungsschicht (4) oberhalb der Schicht (3) mit piezoelektrischen Eigenschaften angeordnet wird.

**20.** Verfahren nach Anspruch 19, **dadurch gekennzeichnet, daß** in einem weiteren Schritt eine elektrisch isolierende und/oder eine feuchtigkeitsisolierende Schicht (5) auf dem Trägerelement (1) angeordnet wird.

**21.** Verfahren nach Anspruch 19 oder 20, **dadurch gekennzeichnet, daß** in einem weiteren Schritt zusätzlich eine Auswerteelektronik nach einem der vorhergehenden Ansprüche auf dem Trägerelement (1) angeordnet wird.
